# EUROPÄISCHE PATENTANMELDUNG

(11) **EP 4 491 775 A1**
(43) Veröffentlichungstag der Anmeldung: **15.01.2025**
(21) Anmeldenummer: 24179637.4
(22) Anmeldetag: 03.06.2024
(51) Int. Cl.: C30B 25/20, C30B 29/04, C30B 31/22, C30B 33/02

(54) **DIAMANTELEMENT UND VERFAHREN ZUR HERSTELLUNG EINES DIAMANTELEMENTS**

(30) Priorität: 10.07.2023 DE 102023206516
(71) Anmelder: Diatope GmbH, 88444 Ummendorf (DE)
(72) Erfinder: FINDLER, Christoph, 89077 Ulm (DE); LANG, Johannes, 89077 Ulm (DE); OSTERKAMP, Christian, 70806 Kornwestheim (DE)
(74) Vertreter: FDST Patentanwälte

(57) **Zusammenfassung**

Die Erfindung betrifft ein Diamantelement (2, 2`), aufweisend ein Substrat (4) mit einem darauf aufgebrachten epitaktischen Schichtsystem (6, 6') aus kohlenstoffisotopenangereicherten Diamantmaterial, wobei das Schichtsystem (6, 6`) mindestens zwei übereinander angeordnete Spinschichten (8a, 8b) mit jeweils einer Spinspezies (14) aufweist, und wobei zwischen zwei Spinschichten (8a, 8b) jeweils eine im Wesentlichen spinfreie Pufferschicht (10) angeordnet ist.

## Beschreibung

Die Erfindung betrifft ein Diamantelement aufweisend ein Substrat mit einem darauf aufgebrachten epitaktischen Schichtsystem aus kohlenstoffisotopenangereicherten Diamantmaterial. Die Erfindung betrifft weiterhin ein Verfahren zur Herstellung eines solchen Diamantelements.

Sogenannte Spinverunreinigungen oder Spindefekte in Feststoffen gehören zu den bisher bekanntesten und meist untersuchten Quantensystemen. Insbesondere Farbzentren in Diamanten, wie beispielsweise negativ geladene Stickstofffehlstellen (engl.: Nitrogen Vacancy, NV) oder Siliziumfehlstellen (engl: Silicone Vacancy, SiV), haben sich als vielseitige, atomgroße Spinsysteme mit einer Vielzahl von Anwendungen in der Quantenoptik, der Quanteninformatik und der Quantensensorik erwiesen.

Für derartige Anwendungen ist es notwendig, dass die Spinsysteme oder Farbzentren mit einer hohen räumlichen Genauigkeit im Nanometerbereich erstellt werden, wobei gleichzeitig möglichst hohe magnetische Spin- und optische Eigenschaften der Farbzentren gewünscht sind. Für NV-Zentren wird dies beispielsweise regelmäßig durch die Implantation von Stickstoffionen mit niedrigen Energien und anschließendem thermischen Ausheizen (Annealing) erreicht. Derartige Ionenimplantationen ermöglichen eine vergleichsweise hohe Positionsgenauigkeit der Farbzentren mit einer räumlichen Auflösung beispielsweise im Bereich von 5 bis 10 nm (Nanometer) bei einer Implantationsenergie von etwa 10 keV (Kiloelektronenvolt).

Für viele Anwendungen, insbesondere auf dem Gebiet der Quanteninformatik, sind koppelnde Spinsysteme gewünscht, bei welchem beispielsweise mindestens zwei Spins miteinander (messbar) wechselwirken. Da die magnetische Wechselwirkung zwischen zwei Spins quadratisch mit dem Spinabstand abnimmt, ist es notwendig, die zu koppelnden Spins möglichst nahe beieinander in dem Diamanten anzuordnen. Mit anderen Worten müssen mindestens zwei Spinsysteme oder Farbzentren in einem Abstand von wenigen Nanometern im Diamantgitter erzeugt werden.

Zur Erzeugung von koppelnden Spinsystemen ist es beispielsweise aus F. Dolde et. al, Nature Physics 9, 139-143 (2013), und M. Haruyama et. al, Nature Communications 10, 2664 (2019, bekannt, Sicktstoffmoleküle (N₂) oder Adenin (C₅N₄Hₙ) zu implantieren, so dass die daraus resultierenden NV-Zentren möglichst nah zueinander angeordnet sind.

Für die Kopplung zwischen einem NV-Zentrum und einem ¹³C-Kernspin ist es beispielsweise aus T. Unden et. al, npj Quantum Information 4, 39 (2018) bekannt, Stickstoff in einen ¹³C-angereicherten Diamanten zu implantieren. Alternativ können intrinsische oder implantierte NV-Zentren in Diamanten mit natürlicher Isotopenzusammensetzung (ca. 1,1 % ¹³C) verwendet werden, wobei bestimmte NV-¹³C-Spinkonfigurationen rein zufällig auftreten.

Erfahrungsgemäß liegen die Erfolgschancen für die Erzeugung von koppelnden (Elektron-Elektron-)Spinsystemen bei den vorstehenden beschriebenen Verfahren bei etwa 1:200 bis 1:500, so dass in der Regel Hunderte von Spins untersucht werden müssen, um ein koppelndes Spinsystem zu identifizieren. Weiterhin gibt es hierbei im Wesentlichen keine Kontrolle über die resultierende Kopplungsstärke, da der Abstand zwischen den koppelnden Spins zufällig ist. Dadurch werden Anwendungen im Bereich der Quanteninformatik nachteilig erschwert.

Der Erfindung liegt die Aufgabe zugrunde, ein besonders geeignetes Diamantelement anzugeben, bei welchem die Spinabstände zwischen koppelnden Spinsystemen einstellbar ist. Insbesondere soll die Zufälligkeit der resultierenden Kopplungsstärke zwischen den Spins reduziert werden. Der Erfindung liegt weiterhin die Aufgabe zugrunde, ein besonders geeignetes Verfahren zur Herstellung des Diamantelements anzugeben.

Hinsichtlich des Diamantelements wird die Aufgabe mit den Merkmalen des Anspruchs 1 und hinsichtlich des Verfahrens mit den Merkmalen des Anspruchs 10 erfindungsgemäß gelöst. Vorteilhafte Ausgestaltungen und Weiterbildungen sind Gegenstand der abhängigen Ansprüche (Unteransprüche). Die im Hinblick auf das Diamantelement angeführten Vorteile und Ausgestaltungen sind sinngemäß auch auf das Verfahren übertragbar und umgekehrt.

Das erfindungsgemäße Diamantelement weist ein Substrat mit einem darauf aufgebrachten oder aufgewachsenen epitaktischen Schichtsystem aus einem kohlenstoffisotopenangereicherten Diamantmaterial auf.

Das Substrat ist insbesondere als ein Diamantsubstrat, also als ein Substrat aus einem Diamantmaterial, ausgeführt, so dass das Schichtsystem insbesondere durch ein homoepitaktisches Wachstum auf dem Substrat hergestellt ist.

Unter einem "Diamantmaterial" ist hier und im Folgenden insbesondere ein synthetisches Einkristall-Diamantmaterial, welches insbesondere mittels einer chemischen Gasphasenabscheidung (engl.: Chemical Vapor Deposition, CVD) hergestellt wurde, zu verstehen. Das Diamantmaterial weist vorzugsweise eine möglichst hohe Reinheit und elektronische Qualität sowie eine möglichst geringe Anzahl von Gitterfehlern auf. Das Diamantmaterial weist beispielsweise einen Stickstoff- und/oder Boranteil kleiner 1 ppb (parts per billion) und einen Isotopenanteil von ¹³C-Kohlenstoff von etwa 1,1 % oder weniger auf.

Vorzugsweise wird ein sogenanntes IIa-(100)-Substrat, also ein Substrat aus einem Typ-Ila Diamantmaterial mit (100)-Oberfläche, verwendet. Prinzipiell kann hier auch ein (111), (110) oder (113)-orientiertes Substrat verwendet werden, die höchste Reinheit hinsichtlich Stickstoff bietet jedoch (100). Bei (100) beträgt der intrinsische Stickstoffgehalt weniger als 50 ppb, was etwa einem intrinsischen NV-Zentrum pro (20 µm)² entspricht.

Das Substrat ist vorzugsweise dünn oder flach ausgeführt, insbesondere weist das Substrat hierbei eine Dicke oder Höhe auf, welche wesentlich geringer als deren Dimensionierung entlang einer Längs- und Querrichtung bemessen ist. Beispielsweise weist das Substrat eine Abmessung von 2 mm (Millimeter) mal 2 mm entlang der Längs- und Querrichtung und eine Abmessung zwischen 10 µm (Mikrometer) bis 500 µm entlang der Dicken- oder Höhenrichtung auf.

Unter einem "kohlenstoffisotopenangereicherten Diamantmaterial" ist hier und im Folgenden insbesondere ein ¹²C-angereichertes Diamantmaterial, also ein Diamantmaterial, welches gegenüber der natürlichen ¹²C/¹³C-Isotopenverteilung einen reduzierten ¹³C-Anteil aufweist, zu verstehen. Der Anteil von ¹²C in dem kohlenstoffisotopenangereicherten Diamantmaterial beträgt vorzugsweise zwischen 98.9 % bis 99.99 %. Das kohlenstoffisotopenangereicherte Diamantmaterial weist vorzugsweise die gleiche Kristallorientierung wie das Substrat, vorzugsweise (100) oder (111), auf.

Das Schichtsystem ist hierbei insbesondere in einem Wachstums- oder Epitaxie-Verfahren, beispielsweise in einem CVD-Verfahren, vorzugsweise in einer homoepitaktischen Diamantsynthese, auf die Oberfläche des Substrats aufgewachsen.

Erfindungsgemäß weist das Schichtsystem mindestens zwei übereinander angeordnete Spinschichten mit jeweils einer Spinspezies auf, wobei zwischen zwei Spinschichten jeweils eine Pufferschicht angeordnet ist. Dadurch ist ein besonders geeignetes Diamantelement realisiert.

Unter einer "Pufferschicht" wird hier und im Folgenden insbesondere eine Schicht aus dem kohlenstoffisotopenangereicherten Diamantmaterial verstanden. Die Pufferschicht ist hierbei im Wesentlichen spinfrei, dies bedeutet, dass lediglich eine sehr geringe Konzentration oder (Spin-)Dichte von (paramagnetischen) Spindefekten oder Spinverunreinigungen im Kristallgitter vorhanden sind. Bei einer (100)-Pufferschicht beträgt der intrinsische Stickstoffgehalt beispielsweise weniger als 50 ppb.

Unter einer "Spinschicht" ist hier und im Folgenden insbesondere eine Schicht des kohlenstoffisotopenangereicherten Diamantmaterials zu verstehen, in welche ein erhöhter Anteil einer jeweiligen Spinspezies eingebracht ist. Der Anteil oder die Konzentration der Spinspezies im Diamantmaterial ist also innerhalb der Spinschicht im Vergleich zu der Pufferschicht erhöht. Die Spinspezies sind beispielsweise durch Ionenimplantation (nach dem Schichtwachstum) oder durch Delta-Doping (während dem Schichtwachstum) in die Spinschicht eingebracht. Die Spinkonzentration oder Spindichte der Spinspezies in der Spinschicht beträgt beispielsweise 1 bis 3 pro (100 nm)². Die Spinkonzentration beträgt insbesondere zwischen 1 ppm und 100 ppm. Die Spinkonzentration innerhalb einer Spinschicht ist beispielsweise mindestens drei Größenordnungen höher als in der Pufferschicht bzw. dem reinen kohlenstoffisotopenangereicherten Diamantmaterial.

Unter einer "Spinspezies" ist hier und im Folgenden eine Spinart, insbesondere eine Spinverunreinigung oder ein Spindefekt, also Elektronen- oder Kernspins, in dem kohlenstoffisotopenangereicherten Diamantmaterial zu verstehen. Vorzugsweise handelt es sich bei der Spinspezies um eine Elektronenspinspezies, beispielsweise um Elektronenspins von Farbzentren, insbesondere von NV- oder SiV-Zentren. Unter einem Farbzentrum ist hierbei ein Punkt- oder Gitterdefekt im Festkörpergitter des kohlenstoffisotopenangereicherten Diamantmaterials zu verstehen, welcher optisch sichtbares Licht absorbiert.

Die Spinschichten können hierbei jeweils die gleiche Spinspezies aufweisen, oder aber mit unterschiedlichen Spinspezies ausgeführt sein. Zweckmäßigerweise weisen die Spinschichten hierbei auch gleiche Spindichten auf. Es sind jedoch auch unterschiedliche Spindichten in den Spinschichten möglich.

Im Nachfolgenden sind Angaben hinsichtlich der Raumrichtungen auch insbesondere in einem Koordinatensystem des Diamantelements bezüglich einer Wachstumsrichtung auf dem Substrat angegeben. Die Abszissenachse (X-Achse, X-Richtung) und die Ordinatenachse (Y-Achse, Y-Richtung) sind hierbei entlang der Längsrichtung (Länge) und Querrichtung (Breite) des Substrats orientiert, wobei die Applikatenachse (Z-Achse, Z-Richtung) entlang der Substrathöhe, also entlang der Wachstumsrichtung entlang welcher das Schichtsystem gewachsen ist, orientiert ist. Die Z-Richtung ist also im Wesentlichen senkrecht oder normal zu den Schichten des Schichtsystems orientiert.

Erfindungsgemäß sind die zu koppelnden Spins (Kern- oder Elektronenspins, z.B. SiV, NV-Zentren) in mindestens zwei separaten Schichten (Spinschichten) angeordnet, welche durch eine nahezu spinfreie Diamantschicht getrennt sind (Pufferschicht). Die Dicke der Pufferschicht dominiert somit die Z-Komponente des Abstandsvektors zwischen den Spinspezies oder Spins der Spinschichten, wodurch sich die Kopplungsstärke zwischen den Spins kontrollieren lässt. Mit anderen Worten ermöglicht die Pufferschicht somit über das Diamantwachstum bei der Herstellung des Schichtsystems das Einstellen von Kopplungsstärken zwischen den Spins, was in anderen Materialanordnungen bisher nicht möglich ist. Das erfindungsgemäße Diamantelement realisiert somit eine kontrollierte Spinkopplung zwischen den Spins der Spinschichten. Dies ist insbesondere für Anwendungen im Bereich der Quanteninformation vorteilhaft, so dass das Diamantelement beispielsweise als ein Diamantchip verwendet werden kann.

In einer geeigneten Weiterbildung weist das Substrat eine kohlenstoffisotopenangereicherte Oberflächenschicht auf. Die Oberflächenschicht ist hierbei aus einem kohlenstoffisotopenangereicherten Diamantmaterial hergestellt, so dass die erste Spinschicht des Schichtsystems durch die Oberflächenschicht von dem Substratmaterial getrennt ist. Insbesondere werden somit ungewünschte Kopplungen zwischen den Spins der ersten Spinschicht und gegebenenfalls vorhandenen (intrinsischen) Spins des Substrats verhindert oder zumindest reduziert. Die Oberflächenschicht weist beispielsweise eine Schichtdicke, also eine Ausdehnung entlang der Z-Richtung, von 10 nm (Nanometer) bis 100 nm, beispielsweise etwa 30 nm, auf. Bei einem IIa-(100)-Substrat wird beispielsweise eine 10 nm bis 100 nm dicke ¹²C-Schicht (98.9 % bis 99.99 % ¹²C-Anteil) mittels CVD als Oberflächenschicht aufgewachsen.

In einer denkbaren Ausführung weisen die Spinschichten jeweils eine Schichtdicke zwischen 0,1 nm und 3 nm auf. Dadurch wird sichergestellt, dass die Spins der Spinspezies eine hohe Genauigkeit oder Lokalisierung entlang der Z-Richtung aufweisen, so dass die Kopplungsstärke mittels der Pufferschicht möglichst genau einstellbar ist.

In einer zweckmäßigen Ausgestaltung weist das Schichtsystem eine Schutzschicht auf, welche auf die äußerste Spinschicht aufgebracht ist. Die Schutzschicht ist hierbei aus dem kohlenstoffisotopenangereicherten Diamantmaterial hergestellt. Dadurch wird die Spinschicht vor Oberflächenverunreinigungen geschützt. Die Schutzschicht isoliert die koppelnden Spins der Spinschichten somit von der Oberfläche beziehungsweise der Umgebung.

Die Schutzschicht weist in einer geeigneten Ausführung eine Schichtdicke zwischen 0,1 nm und 10000 nm auf. Geringere Schichtdicken ermöglichen hierbei eine Kopplung der Spinschicht-Spins an externe Spins, welche beispielsweise an der Oberfläche der Schutzschicht platziert werden. Dies ist beispielsweise vorteilhaft bei Anwendungen des Diamantelements als Quantensensor. Größere Schichtdicken isolieren die Spins des Schichtsystems von der Umgebung, so dass eine besonders effektive und zuverlässige Kontrolle der koppelnden Spins ermöglicht ist. Weiterhin sind die Spineigenschaften, insbesondere die Kohärenzzeit, von tiefen Spins, also bei großen Schutzschichtdicken, besser als bei flachen Spins (kleine Schutzschichtdicken).

Ein zusätzlicher oder weiterer Aspekt der Erfindung sieht vor, dass auf mindestens eine der Spinschichten eine Kernspinschicht mit einer Kernspinspezies aufgebracht ist. Die Kernspinschicht ist also zwischen der Spinschicht und der Pufferschicht (oder Schutzschicht) angeordnet. Mit anderen Worten ist direkt oder unmittelbar angrenzend an der Spinschicht eine Diamantschicht mit einer hohen Anzahl von Kernspins vorgesehen. Da Kernspins eine geringere Kopplungsstärke als Elektronenspins aufweisen, ist es vorteilhaft, die Kernspins unmittelbar benachbart zu den Spins der Spinschicht anzuordnen.

Es werden also beispielsweise Schichten mit variabler Kernspinkonzentration (z.B. 1.5 % bis 99.99 % ¹³C) realisiert, wodurch zusätzlich zu der Kopplung zwischen mindestens zwei Elektronenspins auch Kernspins in die Spinarchitektur aufgenommen werden. Dadurch wird eine Spinarchitektur für das Diamantelement realisiert, bei welchen ein koppelndes Spinsystem der Spinschichten zusätzlich an einen oder mehrere Kernspins gekoppelt ist. Dies ist insbesondere bei Anwendungen in der Quanteninformation vorteilhaft, bei welchem die Kernspins als ein (Quanten-)Register für das koppelnde Spinsystem verwendet werden können.

Die Trennung von Elektronenspins in der Spinschicht von den Kernspins der Kernspinschicht ermöglicht die Kontrolle über die Kernspin-Umgebung und den Abstand der Elektronenspins zu den Kernspins. Die Zufälligkeit der Kopplungsstärke wird dadurch minimiert.

Vorzugsweise weist die oder jede Kernspinschicht eine Schichtdicke zwischen 0,1 nm und 2 nm auf. Dadurch sind geringe Abstände zu den Spins der Spinschicht gewährleistet, wodurch die Wahrscheinlichkeit für eine Kopplung zwischen Kernspinschicht und Spinschicht erhöht wird.

Die Kernspinschichten weisen vorzugsweise die gleiche Kernspinspezies auf, jedoch sind auch Ausführungen mit unterschiedlichen Kernspinspezies denkbar. Die Kernspinkonzentration in den Kernspinschichten kann gleich sein, oder sich unterscheiden.

Beispielsweise wird als Kernspinschicht ein Diamantmaterial mit einem ¹³C-Anteil zwischen 0,1 % und 99,9 % mit einer Schichtdicke zwischen 0,1 nm und 2 nm aufgewachsen. Das Diamantmaterial weist hierbei einen Stickstoffgehalt kleiner 50 ppb, also weniger als 1 NV-Zentrum pro (20 µm)² auf.

Zur schnelleren Lokalisierung von koppelnden Spins in einem Konfokalvolumen eines konfokalen Mikroskops wird die Oberfläche des Diamantelements strukturiert. In einer bevorzugten Ausgestaltung weist das Schichtsystem also eine Oberflächenstrukturierung auf.

Die Koppelreichweite bei einer Elektronenspin-Elektronenspin-Kopplung beträgt etwa 30 nm, und bei einer Elektronenspin-Kernspin-Kopplung etwa 1,5 nm bis 2 nm. Die Oberflächenstrukturierung realisiert weiterhin eine Separierung oder Unterteilung des Schichtsystemvolumens in mehrere kleinere Teilbereiche oder Kopplungsvolumen, so dass koppelnde Spins einfacher selektierbar oder adressierbar sind.

Unter einer Oberflächenstrukturierung ist hierbei beispielsweise eine Strukturierung oder Formgebung zumindest der äußersten Schichten des Schichtsystems zu verstehen. Unter einer Oberflächenstrukturierung sind jedoch auch solche Strukturierungen zu verstehen, welche das Schichtsystem im Wesentlichen vollständig durchsetzen.

Da die Spinspezies der Spinschichten insbesondere als Farbzentren ausgeführt sind, kann als Oberflächenstrukturierung beispielsweise eine photonische Struktur, z.B. ein optischer Resonator oder eine Nanolinse, zur verbesserten Ein- und Auskopplung von Licht verwendet werden, wodurch Messsignale von koppelnden Spinsystemen verbessert werden.

Die Oberflächenstrukturierung ist vorzugsweise als Anzahl von Nanosäulen (Nanopillar) ausgeführt, bei welchem mehrere säulenartige Schichtsysteme freigestellt werden. Derartige Nanosäulen wirken aufgrund deren beispielsweise zylindrischen, konischen, oder kegelstumpfförmigen Form als ein Wellenleiter (engl.: wave guide) für das emittierte Licht der Farbzentren. Die Nanosäulen weisen beispielsweise einen Durchmesser zwischen 50 nm und 500 nm, insbesondere zwischen 100 nm und 300 nm auf. Parallel ermöglicht die Strukturierung eine selektive optische Adressierung von NV- und SiV-Zentren mittels Laser, wenn die Nanosäulen ausreichend weit voneinander entfernt sind.

In einer denkbaren Weiterbildung wird die Oberflächenstrukturierung, insbesondere die Nanosäulen, mit einer Pufferschicht überwachsen, um die Kohärenz- sowie optischen Eigenschaften der Spinspezies zu verbessern.

Das erfindungsgemäße Verfahren ist zur Herstellung eines vorstehend beschriebenen Diamantelements vorgesehen sowie dafür geeignet und ausgestaltet.

Verfahrensgemäß wird zunächst ein Substrat, insbesondere ein Diamantsubstrat, bereitgestellt. Vorzugsweise wird das Substrat vorab gereinigt. Zur Reinigung des Diamantmaterials beziehungsweise der Oberfläche wird das Substrat beispielsweise in einer Säurelösung von Schwefelsäure (H₂SO₄) und Salpetersäure (HNOs) sowie Perchlorsäure (HClO₄) gereinigt.

Auf die Oberfläche des Substrats wird anschließend das Schichtsystem mit mindestens zwei Spinschichten und einer dazwischen angeordneten Pufferschicht epitaktisch aufgewachsen. Insbesondere wird hierbei kohlenstoffisotopenangereichertes Diamantmaterial aufgewachsen. Das kohlenstoffisotopenangereichertes Diamantmaterial wird insbesondere in einem Wachstums- oder Epitaxie-Verfahren, beispielsweise in einem CVD-Verfahren, vorzugsweise in einer homoepitaktischen Diamantsynthese, auf die Oberfläche des Substrats, insbesondere der Oberflächenschicht, aufgewachsen.

Zur Herstellung einer Pufferschicht wird hierbei das kohlenstoffisotopenangereicherte Diamantmaterial aufgewachsen. Zur Herstellung einer Spinschicht wird kohlenstoffisotopenangereichertes Diamantmaterial aufgewachsen, in welches eine jeweilige Spinspezies eingebracht wird. Die Spinspezies wird beispielsweise nach dem Aufwachsen mittels Ionenimplantation in das Diamantmaterial eingebracht. Alternativ kann die Spinspezies in Form eines Delta-Dopings, bei welchem das aufgewachsene Diamantmaterial mit Fremdatomen, also Atomen welche nicht Kohlenstoff sind, dotiert oder versetzt ist, in das Diamantmaterial während des Aufwachsens eingebracht werden.

Dadurch ist ein besonders geeignetes Verfahren realisiert. Das Verfahren ermöglicht die kontrollierte Realisierung von Elektronspin-Elektronspin-Kopplung von Spinsystemen, die wahlweise oder optional um eine Kopplung an Kernspins erweitert werden kann.

Nach dem Aufwachsen des Schichtsystems wird das Diamantelement vorzugsweise getempert oder ausgeheizt, so dass Wasserstoff (H2) aus dem Diamantgitter beziehungsweise der Gitterstruktur des Diamantmaterials hinaus diffundiert. Dadurch wird die Qualität und Reinheit des Schichtsystems beziehungsweise des Diamantmaterials verbessert. Hierzu wird das Diamantelement beispielsweise unter Hochvakuum bei 700 °C bis 1600 °C für mindestens drei Stunden ausgeheizt. Bei einer durch Ionenimplantation hergestellten Spinschicht diffundieren die durch die Implantation erzeugten Fehlstellen (engl.: Vancancies) durch das Diamantgitter und kombinieren mit dem implantierten Stickstoff zu NV-Zentren beziehungsweise bei implantierten Silizium zu SiV-Zentren. Anschließend wird das Diamantelement beispielsweise erneut in einer Säurelösung gereinigt und beispielsweise mit einer Oberflächenstrukturierung versehen. Optional kann die Oberflächenstrukturierung abschließend mit einer Pufferschicht überwachsen werden.

Nachfolgend sind Ausführungsbeispiele der Erfindung anhand einer Zeichnung näher erläutert. Darin zeigen in schematischen und vereinfachten Darstellungen:
- Fig. 1: in Seitenansicht ein Diamantelement in einer ersten Ausführungsform,
- Fig. 2: ein Flussdiagramm für ein Verfahren zur Herstellung eines Diamantelements in einer ersten Ausführungsform,
- Fig. 3: ein Diamantelement in einer zweiten Ausführungsform, und
- Fig. 4: ein Flussdiagramm für ein Verfahren zur Herstellung eines Diamantelements in einer ersten Ausführungsform.

Einander entsprechende Teile und Größen sind in allen Figuren stets mit den gleichen Bezugszeichen versehen.

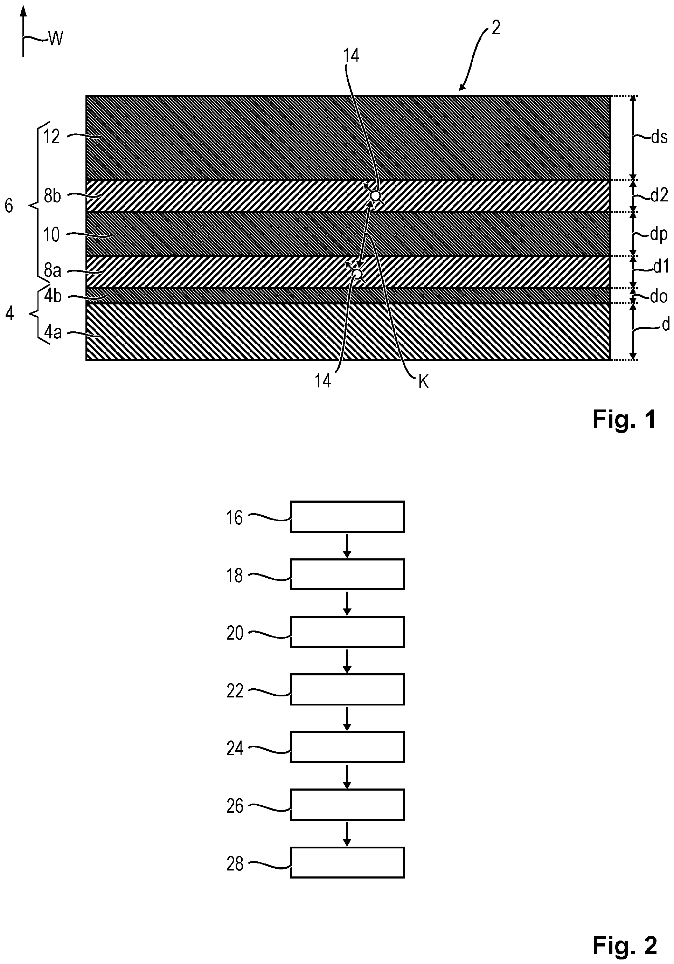

Das in Fig. 1 gezeigte Diamantelement 2 weist ein Substrat 4 und ein epitaktisches Schichtsystem 6 auf.

Das Substrat 4 weist beispielsweise ein Substratelement 4a und eine darauf aufgewachsene Oberflächenschicht 4b auf.

Das Schichtsystem 6 weist in dem gezeigten Ausführungsbeispiel zwei Spinschichten 8a, 8b, eine Pufferschicht 10, und eine Schutzschicht 12 auf. Die Spinschicht 8a ist hierbei auf der Oberfläche des Substrats 4 angeordnet, wobei die Pufferschicht 10 zwischen den Spinschichten 8a und 8b positioniert ist. Die Schutzschicht 12 ist auf die obere Spinschicht 8b aufgebracht.

In den Spinschichten 8a und 8b ist jeweils eine Spinspezies 14 eingebracht. Die Spins der Spinspezies 14 sind in den Figuren lediglich beispielsweise gezeigt und mit Bezugszeichen versehen. Die Spins der Spinschichten 8a und 8b können Spins der gleichen Spinspezies 14 sein. Alternativ sind die Spins der Spinschichten 8a und 8b unterschiedlichen Spinspezies 14 zugeordnet. Nachfolgend sind die Spins 14 (ohne Beschränkung der Allgemeinheit) insbesondere Elektronenspins eines Farbzentrums, beispielsweise eines NV-Zentrums.

Das Substratelement 4a ist als ein Ila-(100)-Diamant ausgeführt, auf welchen die Oberflächenschicht 4b in einem homoepitaktischen Wachstumsprozess aufgewachsen ist. Das Substratelement 4a weist entlang einer in Z-Richtung orientierten Wachstumsrichtung W eine Schichtdicke d auf. Die Schichtdicke d ist beispielsweise zwischen 10 µm und 2 mm, insbesondere zwischen 50 µm und 500 µm, dimensioniert. Grundsätzlich kann das Substratelement 4a jedoch eine beliebige Schichtdicke d aufweisen.

Die Oberflächenschicht 4b ist eine ¹²C-Schicht, und ist aus einem isotopenangereicherten Diamantmaterial mit beispielsweise 99,99 % ¹²C-Anteil mittels CVD auf die Oberfläche des Substratelements 4a aufgewachsen. Der intrinsische Stickstoffgehalt der Oberflächenschicht 4b ist kleiner 50 ppb beziehungsweise kleiner ein NV pro (20 µm)². Die Oberflächenschicht 4b weist eine Schichtdicke do auf, welche zwischen 10 nm und 100 nm dimensioniert ist. In dem Ausführungsbeispiel der Fig. 1 beträgt die Schichtdicke do beispielsweise 30 nm.

Die Spinschicht 8a ist aus einem isotopenangereicherten Diamantmaterial mit beispielsweise 99,99 % ¹²C-Anteil mittels CVD auf die Oberfläche der Oberflächenschicht 4b homoepitaktisch aufgewachsen. Nach dem Aufwachsen ist mittels Ionenimplantation Stickstoff in das Diamantmaterial der Spinschicht 8a eingebracht, wobei die NV-Dichte nach der Fertigstellung des Schichtsystems 6 und nach einem Ausheizen etwa 1/(100 nm)² beträgt. Die Spinschicht 8a weist eine Schichtdicke d1 zwischen 0,1 nm und 3 nm auf. In dem Ausführungsbeispiel der Fig. 1 beträgt die Schichtdicke d1 beispielsweise 3 nm. Der Stickstoffgehalt in der 3 nm dicken Spinschicht 8a beträgt etwa 94 ppm.

Die Pufferschicht 10 ist eine 0,1 nm bis 30 nm dicke Diamantschicht aus einem isotopenangereicherten Diamantmaterial mit beispielsweise 99,99 % ¹²C-Anteil, welches mittels CVD auf die Oberfläche der Spinschicht 8a homoepitaktisch aufgewachsen wird. Der intrinsische Stickstoffgehalt der Pufferschicht 10 ist kleiner 50 ppb beziehungsweise kleiner ein NV pro (20 µm)² Die Pufferschicht 10 weist eine Schichtdicke dp auf, welche in dem Ausführungsbeispiel der Fig. 1 beispielsweise auf 15 nm dimensioniert ist.

Die Spinschicht 8b ist aus einem isotopenangereicherten Diamantmaterial mit beispielsweise 99,99 % ¹²C-Anteil mittels CVD auf die Oberfläche der Pufferschicht 10 homoepitaktisch aufgewachsen. Nach dem Aufwachsen ist mittels Ionenimplantation Stickstoff in das Diamantmaterial der Spinschicht 8b eingebracht, wobei die NV-Dichte nach der Fertigstellung des Schichtsystems 6 und nach einem Ausheizen etwa 1/(100 nm)² beträgt. Die Spinschicht 8b weist eine Schichtdicke d2 zwischen 0,1 nm und 3 nm auf. In dem Ausführungsbeispiel der Fig. 1 beträgt die Schichtdicke d2 beispielsweise 3 nm. Der Stickstoffgehalt in der 3 nm dicken Spinschicht 8a beträgt etwa 75 ppm.

Vorzugsweise weist die untere Spinschicht 8a eine im Vergleich zur oberen Spinschicht 8b erhöhten Stickstoffgehalt auf. Im Ausführungsbeispiel beträgt der Stickstoffgehalt der Spinschicht 8a beispielsweise 94 ppm, und der Stickstoffgehalt der Spinschicht 8b etwa 75 ppm. Der Stickstoffgehalt der tieferliegenden Spinschicht 8a wird höher gewählt, da durch den Überwachsprozess der Pufferschicht 10 NVs verloren gehen können. Durch die unterschiedlichen Stickstoffgehälter erhöht sich somit die Wahrscheinlichkeit ein koppelndes Spinpaar zu erhalten.

Die Schutzschicht 12 ist aus einem isotopenangereicherten Diamantmaterial mit beispielsweise 99,99 % ¹²C-Anteil mittels CVD auf die Oberfläche der Spinschicht 8b homoepitaktisch aufgewachsen. Der intrinsische Stickstoffgehalt der Schutzschicht 12 ist kleiner 50 ppb beziehungsweise kleiner ein NV pro (20 µm)². Die Schutzschicht 12 weist eine Schichtdicke ds zwischen 0,1 nm und 10000 nm auf, welche in dem Ausführungsbeispiel der Fig. 1 beispielsweise auf 30 nm dimensioniert ist.

Das Diamantelement 2 ist dazu vorgesehen und eingerichtet koppelnde Spinsysteme zu realisieren. Insbesondere sollen hierbei koppelnde Spinsysteme aus zumindest einem Spin 14 der Spinschicht 8a und einem Spin 14 der Spinschicht 8b realisiert werden. In den Figuren ist die Kopplung K oder Wechselwirkung zwischen den Spins 14 als ein Doppelpfeil schematisch gezeigt.

Die zu koppelnden Spins 14 sind hierzu in den zwei separaten Spinschichten 8a, 8b angeordnet, welche durch die nahezu spinfreie Pufferschicht 10 voneinander getrennt sind. Die Schichtdicke dp der Pufferschicht 10 dominiert somit die Z-Komponente des Abstandsvektors zwischen den Spins 14 der Spinschichten 8a, 8b, wodurch sich die Kopplungsstärke der Kopplung K zwischen den Spins 14 kontrollieren lässt. Mit anderen Worten ermöglicht die Pufferschicht 10 somit über das Diamant-Wachstum bei der Herstellung des Schichtsystems 6 das Einstellen von Kopplungsstärken zwischen den Spins 14, was in anderen Materialanordnungen bisher nicht möglich ist.

Nachfolgend ist anhand der Figur 2 ein Verfahren ist zur Herstellung eines Diamantelements 2 näher erläutert.

In einem ersten Verfahrensschritt 16 wird das Substratelement 4a bereitgestellt. Vorzugsweise wird das Substratelement 4a zunächst in einer Säurelösung gereinigt.

In dem Verfahrensschritt 18 wird auf die Oberfläche des Substratelements 4a eine Diamantschicht aus kohlenstoffisotopenangereicherten Diamantmaterial aufgewachsen. Hierbei wird eine Schichtdicke aufgewachsen, welche der Summe der Schichtdicken do und d1 der Oberflächenschicht 4b und der Spinschicht 8a entspricht.

In einem anschließenden Verfahrensschritt 20 werden ¹⁵N⁺-Ionen mittels Ionenimplantation in das Diamantgitter der Schichtdicke d1 eingebracht, und somit die Spinschicht 8a gebildet.

In dem darauffolgenden Verfahrensschritt 20 wird auf die Oberfläche der Spinschicht 8a eine Diamantschicht aus kohlenstoffisotopenangereicherten Diamantmaterial aufgewachsen. Hierbei wird eine Schichtdicke aufgewachsen, welche der Summe der Schichtdicken dp und d2 der Pufferschicht 10 und der Spinschicht 8b entspricht.

In einem anschließenden Verfahrensschritt 22 werden ¹⁵N⁺-Ionen mittels Ionenimplantation in das Diamantgitter der Schichtdicke d2 eingebracht, und somit die Spinschicht 8b gebildet.

Hiernach wird in dem Verfahrensschritt 24 eine Diamantschicht aus kohlenstoffisotopenangereicherten Diamantmaterial mit der Schichtdicke ds als Schutzschicht 12 auf die Oberfläche der Spinschicht 8b aufgewachsen.

Nach dem Aufwachsen des Schichtsystems 6 wird das Diamantelement 2 in einem Verfahrensschritt 26 getempert oder ausgeheizt. Im Anschluss an das Ausheizen wird das Diamantelement 2 beispielsweise erneut in einer Säurelösung gereinigt.

In einem optionalen Verfahrensschritt 28 wird die Oberfläche des Diamantelements 2, insbesondere das Schichtsystem 6, strukturiert. Als Oberflächenstrukturierung werden hierbei insbesondere Nanosäulen des Schichtsystems 6 hergestellt. Hierzu wird eine entsprechende lithografische Maske auf die Oberfläche der Schutzschicht 12 aufgebracht und anschließend das Diamantelement 2 beispielsweise mittels eines reaktiven Plasmas geätzt, so dass einzelne Nanosäulen des Schichtsystems 6 freigestellt werden. Die Nanosäulen können anschließend mit einer weiteren Pufferschicht überwachsen werden.

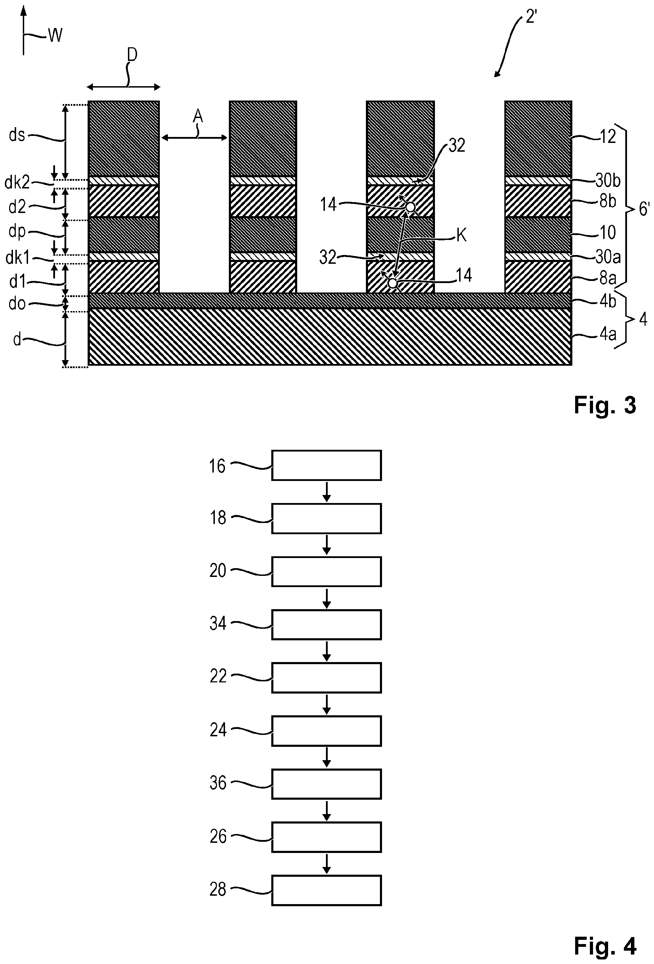

Nachfolgend ist anhand der Figuren 3 und 4 ein zweites Ausführungsbeispiel für das Diamantelement 2' sowie ein entsprechendes (Herstellungs-)Verfahren näher erläutert.

Das Diamantelement 2' weist eine Oberflächenstrukturierung des Schichtsystems 6' in Form von Nanosäulen auf. Die Nanosäulen weisen hierbei beispielsweise einen Durchmesser D zwischen 10 nm und 1000 nm auf, wobei ein Abstand A zwischen zwei benachbarten Nanosäulen beispielsweise zwischen 500 nm und 50 µm beträgt. Die Nanosäulen sind somit weit genug voneinander entfernt, dass mittels eines konfokalen Mikroskops die Spins 14 beziehungsweise Farbzentren einer einzelnen Nanosäule messbar sind.

Das Diamantelement 2' beziehungsweise das Schichtsystem 6' weist in dieser Ausführung zwei zusätzliche Kernspinschichten 30a, 30b auf, welche jeweils auf einer der Spinschichten 8a, 8b aufgewachsen sind. Die Kernspinschicht 30a ist hierbei zwischen der Spinschicht 8a und der Pufferschicht 10 und die Kernspinschicht 30b ist zwischen der Spinschicht 8b und der Schutzschicht 12 angeordnet.

In den Kernspinschichten 30a und 30b sind jeweils Kernspins einer Kernspinspezies 32 eingebracht. Die Kernspins der Kernspinspezies 32 sind in der Fig. 3 lediglich beispielhaft gezeigt und mit Bezugszeichen versehen. Die Kernspins 32 der Kernspinschichten 30a und 30b können Kernspins der gleichen Kernspinspezies sein. Alternativ können die Kernspins 32 der Kernspinschichten 30a,30b auch zu unterschiedlichen Kernspinspezies gehören.

Vorzugsweise handelt es sich bei den Kernspins 32 um ¹³C-Kernspins. Die Kernspinschichten 30a, 30b weisen somit im Vergleich zu dem Diamantmaterial der Schichten 4a, 8a, 8b, 10, und 12 einen erhöhten Anteil von ¹³C auf. Beispielsweise werden als Kernspinschichten 30a, 30b jeweils ein Diamantmaterial mit einem ¹³C-Anteil zwischen 0,1 % und 99,9 % mit einer Schichtdicke dk1, dk2 zwischen 0,1 nm und 2 nm aufgewachsen. Das Diamantmaterial der Kernspinschichten 30a, 30b weist hierbei einen Stickstoffgehalt kleiner 50 ppb, also weniger als 1 NV-Zentrum pro (20 µm)² auf.

Das in Fig. 4 gezeigte Verfahren zur Herstellung des Diamantelements 2' unterscheidet sich hierbei von dem vorstehend beschriebenen Verfahren der Fig. 2 durch zwei zusätzliche Verfahrensschritte 34, 36 beim Aufwachsen des Schichtsystems 6`.

Der Verfahrensschritt 34 wird zwischen den Verfahrensschritten 20 und 22 ausgeführt. In dem Verfahrensschritt 34 wird auf die Oberfläche der Spinschicht 8a das ¹³C angereicherte Diamantmaterial der Kernspinschicht 30a aufgewachsen. Hierbei wird eine Schichtdicke dk1 aufgewachsen, welche zwischen 0,1 nm und 2 nm dimensioniert ist.

Entsprechend wird der Verfahrensschritt 36 zwischen den Verfahrensschritten 24 und 26 ausgeführt. Hierbei wird auf die Oberfläche der Spinschicht 8b das ¹³C angereicherte Diamantmaterial der Kernspinschicht 30b mit einer Schichtdicke dk2 aufgewachsen, welche zwischen 0,1 nm und 2 nm dimensioniert ist.

Die beanspruchte Erfindung ist nicht auf die vorstehend beschriebenen Ausführungsbeispiele beschränkt. Vielmehr können auch andere Varianten der Erfindung von dem Fachmann hieraus im Rahmen der offenbarten Ansprüche abgeleitet werden, ohne den Gegenstand der beanspruchten Erfindung zu verlassen. Insbesondere sind ferner alle im Zusammenhang mit den verschiedenen Ausführungsbeispielen beschriebenen Einzelmerkmale im Rahmen der offenbarten Ansprüche auch auf andere Weise kombinierbar, ohne den Gegenstand der beanspruchten Erfindung zu verlassen.

### Bezugszeichenliste

- 2, 2': Diamantelement
- 4: Substrat
- 4a: Substratelement
- 4b: Oberflächenschicht
- 6, 6': Schichtsystem
- 8a, 8b: Spinschicht
- 10: Pufferschicht
- 12: Schutzschicht
- 14: Spin, Spinspezies
- 16, ..., 28: Verfahrensschritt
- 30a, 30b: Kernspinschicht
- 32: Kernspin, Kernspinspezies
- 34, 36: Verfahrensschritt

- W: Wachstumsrichtung
- d, do, d1, d2, dp, ds, dk1, dk2: Schichtdicke
- K: Kopplung
- D: Durchmesser
- A: Abstand

## Patentansprüche

1. Diamantelement (2, 2`), aufweisend ein Substrat (4) mit einem darauf aufgebrachten epitaktischen Schichtsystem (6, 6`) aus kohlenstoffisotopenangereicherten Diamantmaterial,
- wobei das Schichtsystem (6, 6`) mindestens zwei übereinander angeordnete Spinschichten (8a, 8b) mit jeweils einer Spinspezies (14) aufweist, und
- wobei zwischen zwei Spinschichten (8a, 8b) jeweils eine im Wesentlichen spinfreie Pufferschicht (10) angeordnet ist.

2. Diamantelement (2, 2`) nach Anspruch 1,
**dadurch gekennzeichnet,**
**dass** das Substrat (4) eine kohlenstoffisotopenangereicherte Oberflächenschicht (4b) aufweist.

3. Diamantelement (2, 2`) nach Anspruch 1 oder 2,
**dadurch gekennzeichnet,**
**dass** die Spinschichten (8a, 8b) jeweils eine Schichtdicke (d1, d2) zwischen 0,1 nm und 3 nm aufweisen.

4. Diamantelement (2, 2`) nach einem der Ansprüche 1 bis 3,
**dadurch gekennzeichnet,**
**dass** die oder jede Pufferschicht (10) eine Schichtdicke (dp) zwischen 0,1 nm und 30 nm aufweist.

5. Diamantelement (2, 2`) nach einem der Ansprüche 1 bis 4,
**dadurch gekennzeichnet,**
**dass** das Schichtsystem (6, 6`) eine Schutzschicht (12) aufweist, welche auf die äußerste Spinschicht (8b) aufgebracht ist.

6. Diamantelement (2, 2`) nach Anspruch 5,
**dadurch gekennzeichnet,**
**dass** die Schutzschicht (12) eine Schichtdicke (ds) zwischen 0,1 nm und 10000 nm aufweist.

7. Diamantelement (2, 2`) nach einem der Ansprüche 1 bis 6,
**dadurch gekennzeichnet,**
**dass** auf mindestens eine der Spinschichten (8a, 8b) eine Kernspinschicht (30a, 30b) mit einer Kernspinspezies (32) aufgebracht ist.

8. Diamantelement (2, 2`) nach Anspruch 7,
**dadurch gekennzeichnet,**
**dass** die oder jede Kernspinschicht (30a, 30b) eine Schichtdicke (dk1, dk2) zwischen 0,1 nm und 2 nm aufweist.

9. Diamantelement (2, 2`) nach einem der Ansprüche 1 bis 8,
**dadurch gekennzeichnet,**
**dass** das Schichtsystem (6, 6`) eine Oberflächenstrukturierung aufweist.

10. Verfahren zur Herstellung eines Diamantelements (2, 2`) nach einem der Ansprüche 1 bis 9,
- wobei ein Substrat (4) bereitgestellt wird,
- wobei auf das Substrat (4) zumindest zwei Spinschichten (8a, 8b) mit einer dazwischen angeordneten Pufferschicht (10) als epitaktisches Schichtsystem (6, 6`) aufgewachsen werden,
- wobei zur Herstellung einer Spinschicht (8a, 8b) kohlenstoffisotopenangereichertes Diamantmaterial aufgewachsen wird, in welches eine jeweilige Spinspezies (14) eingebracht wird, und
- wobei zur Herstellung einer Pufferschicht (10) kohlenstoffisotopenangereichertes Diamantmaterial aufgewachsen wird.
